Europäisches Patentamt

European Patent Office

Office européen des brevets

(19)

(11) Numéro de publication : **0 148 085**
**B1**

(12) **FASCICULE DE BREVET EUROPÉEN**

(45) Date de publication du fascicule du brevet :
25.05.88

(51) Int. Cl.⁴ : **H 03 B   9/00**, H 05 B   6/68

(21) Numéro de dépôt : **84402701.1**

(22) Date de dépôt : **21.12.84**

(54) Dispositif de mise sous tension d'un circuit d'alimentation pour magnétron, notamment pour four à microonde.

(30) Priorité : 27.12.83 FR 8320843

(43) Date de publication de la demande :
10.07.85 Bulletin 85/28

(45) Mention de la délivrance du brevet :
25.05.88 Bulletin 88/21

(84) Etats contractants désignés :
DE GB SE

(56) Documents cités :
FR-A- 1 477 092
US-A- 3 780 252
US-A- 4 023 004
US-A- 4 358 729
PATENTS ABSTRACTS OF JAPAN, vol. 2, no. 53, 17
avril 1978, page 1138 E 78; & JP - A - 53 17 202
(SHINNIPPON DENKI K.K.) 17-02-1978

(73) Titulaire : ESSWEIN S.A.
Route de Cholet
F-85002 La Roche-sur-Yon (FR)

(72) Inventeur : Didier, Laurent
SCPI - 173, bld Haussmann
F-75379 Paris Cedex 08 (FR)
Inventeur : Geay, Jean-Claude
SCPI - 173, bld Haussmann
F-75379 Paris Cedex 08 (FR)

(74) Mandataire : Grynwald, Albert et al
THOMSON-CSF SCPI 19, avenue de Messine
F-75008 Paris (FR)

EP 0 148 085 B1

Jouve, 18, rue St-Denis, 75001 Paris, France

## Description

La présente invention concerne un dispositif de mise sous tension, c'est-à-dire de démarrage en mode de fonctionnement continu et de redémarrage en mode de fonctionnement intermittent, d'un circuit d'alimentation d'un ou plusieurs magnétrons.

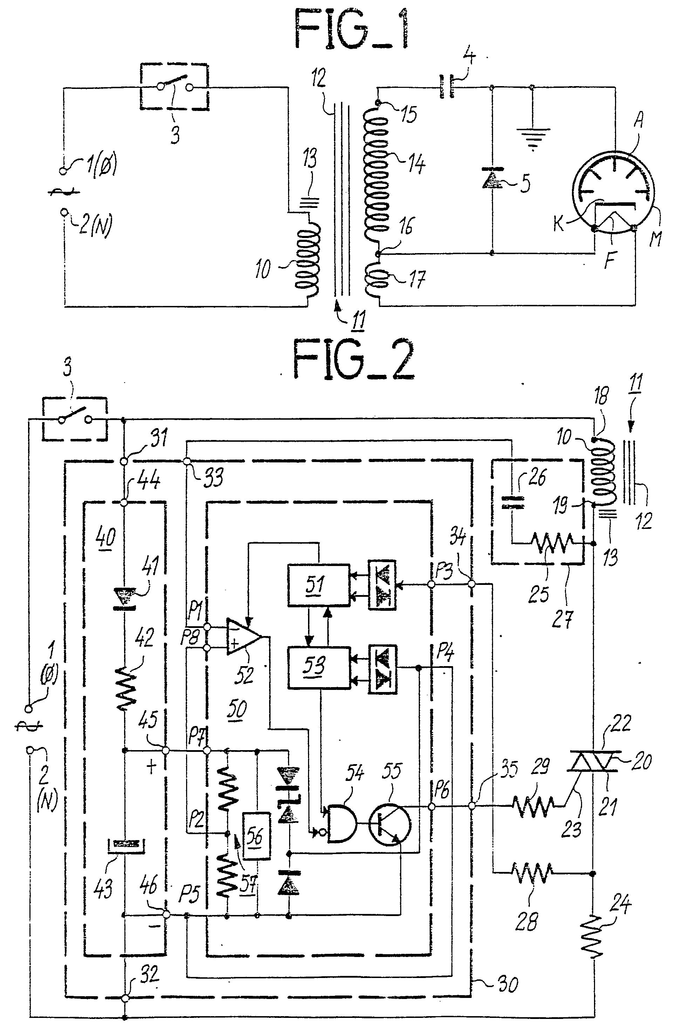

Un circuit d'alimentation pour magnétron, utilisable notamment dans les fours ou enceintes à micro-ondes, a été décrit dans la publication FR-A-1 477 092 et l'un de ses modes de réalisation a été reproduit schématiquement sur la figure 1 du dessin annexé. Le circuit de la figure 1 comprend deux bornes d'entrée 1 et 2, dont la première 1 est reliée à une phase (∅) et dont la seconde 2, au neutre (N) du réseau alternatif de distribution (secteur). La borne 1 est reliée, par l'intermédiaire d'un interrupteur 3 de mise sous tension, à l'une des bornes d'un enroulement primaire 10 d'un transformateur 11 élévateur de tension, à inductance de fuite élevée, tandis que la borne 2 est reliée à l'autre borne de cet enroulement 10. Cette inductance de fuite élevée est obtenue, par exemple, en ajoutant au circuit magnétique feuilleté et fermé 12 du transformateur 11, un shunt magnétique 13 disposé de telle sorte qu'une partie du flux magnétique engendré par le courant alternatif dans l'enroulement primaire 10 se referme sur lui-même, ce qui équivaut à un couplage très lâche. Le transformateur 11 comporte en outre un premier enroulement secondaire 14 de très haute tension (T.H.T.) dont une première borne 15 est reliée à une première armature d'un condensateur 4. La seconde armature de ce condensateur 4 est reliée, d'une part, à l'anode A du magnétron M qui est à la masse et d'autre part, à la cathode d'une diode de redressement 5 dont l'anode est reliée, d'une part, à l'autre borne 16 de l'enroulement T.H.T. et d'autre part, à la cathode K du magnétron M. Un second enroulement secondaire 17, dit de chauffage, dont les bornes sont respectivement reliées à celles du filament F du magnétron M, est relié par l'une d'elles à l'autre borne 16 de l'enroulement T.H.T. 14 de sorte que la cathode K et le filament F sont au même potentiel. Le magnétron M peut, du fait qu'il ne conduit le courant que dans le sens anode-cathode, être assimilé à une diode qui est connectée à l'envers par rapport à la diode 5, avec une charge résistive en série.

Lors d'une première alternance négative de la tension entre les bornes 15 et 16 de l'enroulement T.H.T. 14, la diode 5 conduit et charge le condensateur 4 de telle sorte que son armature reliée à la borne 15 devient négative par rapport à son autre armature qui est reliée à la masse. Au cours de l'alternance positive suivante de la tension entre les bornes 15 et 16, la diode 5 se bloque et le magnétron M devient conducteur dans le sens opposé en déchargeant, au moins en partie, le condensateur 4. Si la capacité de ce condensateur 4 est choisie suffisamment élevée pour qu'il ne devienne pas entièrement déchargé à la fin de chaque intervalle de conduction du magnétron M, le rapport de transformation entre l'enroulement primaire 10 et l'enroulement T.H.T. 14 peut être choisi de façon à tenir compte de la charge résiduelle de ce condensateur 4 qui présente alors un effet analogue à celui d'un doubleur de tension.

L'effet conjugué de l'inductance de fuite élevée et du condensateur 4 permet d'obtenir une stabilisation du courant anodique du magnétron M, qui est décrite dans la publication précitée. La diode 5 qui a, en outre, pour fonction de faire débiter l'enroulement secondaire 14 au cours des deux alternances, peut être remplacée par un autre magnétron connecté à l'envers par rapport à celui M représenté sur la figure 1 (voir la figure 7 de la publication précitée), qui fonctionne en alternance avec l'autre et qui peut alimenter la même (ou une autre) enceinte à micro-ondes.

On a constaté qu'un tel circuit d'alimentation pour magnétron présente un inconvénient majeur lors de sa mise sous tension : un surcroît initial du courant consommé dont la pointe (valeur crête) peut atteindre jusqu'à vingt fois la valeur efficace du courant en régime établi.

Ces transitoires de courant à la mise sous tension par un interrupteur à contacts, à commande mécanique ou électromagnétique, sont de forme et d'amplitude imprévisibles et peuvent rendre inopérante la plupart des dispositifs de sécurité pour installations domestiques, tels que des fusibles lents (temporisés) ou rapides, ou des disjoncteurs électromagnétiques réenclenchables, par exemple, qui ne sont généralement pas prévus pour absorber des appels de courant de plusieurs dizaines, jusqu'à une centaine, d'ampères. En outre, de tels appels de courant se répercutent sur le secteur sous la forme de baisses de tension temporaires et de parasites. Ces phénomènes déjà connus, notamment de la technique de commutation de puissance pour le chauffage électrique résistif ou par induction à l'aide de convertisseurs statiques (onduleurs, par exemple), ont conduit à des circuits de démarrage « doux » utilisant des interrupteurs statiques du type thyristor ou triac, qui sont déclenchés en synchronisme avec les passages par zéro de la tension alternative d'alimentation, afin que le courant de démarrage ne puisse croître que graduellement.

Du fait que le magnétron M n'entre en oscillation stable dans un mode déterminé qu'à partir d'une certaine tension minimale, qui ne doit varier que de dix à vingt pour cent environ, il n'est pas possible d'obtenir une régulation de la puissance moyenne fournie à l'enceinte par la variation de la tension d'alimentation.

Pour un fonctionnement régulier et fiable, il faut que le magnétron fournisse une puissance proche de sa valeur maximale. Ceci conduit à un type de réglage de la puissance moyenne fournie par le rapport cyclique de son fonctionnement qui, par conséquent, doit être intermittent. Plus précisément, un tel réglage signifie que durant l'opération de chauffage par micro-ondes à l'aide du magnétron, celui-ci est soumis à de multiples périodes de fonctionnement et d'arrêt alternées, dont les durées respectives varient en sens inverse, la somme des durées d'une période de fonctionnement et d'une période d'arrêt consécutives étant constante et appelée dans ce qui suit une période de référence (ou découpage).

La puissance maximale est fournie lorsque la période de fonctionnement égale celle de référence, c'est-à-dire pour un rapport cyclique unitaire indiquant un fonctionnement ininterrompu. Le réglage de la puissance par le rapport cyclique implique, hors le premier démarrage à la mise en route, de multiples redémarrages périodiques, dont chacun peut engendrer un transitoire ou appel de courant d'amplitude aléatoire.

Il est également connu d'utiliser au démarrage des résistances de protection initialement connectées en série avec l'enroulement primaire 10 du transformateur 11, qui sont ensuite court-circuitées à l'aide par exemple de relais temporisés ou non, ou de thermistances à coefficient de température négatif.

On a constaté que l'amplitude de ces appels de courant est fonction de la phase de la tension d'alimentation alternative à l'instant de la fermeture de l'interrupteur 3 et que, du fait des déphasages complexes respectivement occasionnés par les inductances de fuite élevées du transformateur 11 et la présence du condensateur 4 dans le circuit de son enroulement secondaire T.H.T. 14, les amplitudes minimales du transitoire de courant coïncidaient sensiblement avec les maxima et minima de la tension du réseau.

On sait (voir par exemple les publications JP-A-5 317 202 ou US-A-4 358 729) qu'en synchronisant l'instant de la première mise sous tension de l'enroulement primaire du transformateur d'alimentation avec une valeur de crête de la tension du réseau alternatif, consécutivement à chaque arrêt, on réduit l'amplitude des appels de courant de démarrage sensiblement à leur valeur minimale. On peut également, de ce fait, utiliser un réglage de la puissance par le rapport cyclique.

L'invention par de la constatation que les circuits connus, qui permettent d'assurer une telle synchronisation de la première mise sous tension du primaire du transformateur avec une valeur de crête de la tension du réseau, sont d'un prix élevé car ils ne sont utilisables pratiquement que pour l'alimentation d'un magnétron.

L'invention telle que caractérisée dans la revendication 1 remédie à cet inconvénient, c'est-à-dire qu'elle fournit un circuit de commande particulièrement économique.

On fait ainsi appel à un circuit intégré classique de détection de passage par zéro et fabriqué en très grande série et donc à bon marché. Un déphaseur est également un élément économique.

L'invention sera mieux comprise et d'autres de ses objets, caractéristiques et avantages ressortiront de la description qui suit et des dessins annexés s'y rapportant, donnés à titre d'exemple, sur lesquels :

— la figure 1 reproduit schématiquement un circuit d'alimentation pour magnétron connu, qui a été décrit précédemment ;

— la figure 2 est un schéma de principe partiel, en partie synoptique, d'un mode de réalisation du dispositif de mise sous tension du circuit d'alimentation pour magnétron suivant l'invention ;

— les figures 3A à 3E sont des diagrammes de diverses formes d'onde de tensions et/ou de courants à divers endroits du circuit de la figure 2 ;

— la figure 4 est un schéma de principe partiellement synoptique du mode de réalisation du dispositif de la figure 2 complété d'un circuit permettant le réglage de la puissance fournie, par le rapport cyclique ; et

— les figures 5A et 5B sont des diagrammes de diverses formes d'onde de tension à deux endroits du circuit de la figure 4.

Sur toutes les figures, les mêmes éléments ont été désignés par les mêmes références.

Sur la figure 2, on a représenté schématiquement le circuit de l'enroulement primaire 10 du transformateur 11 d'alimentation du magnétron M (de la fig. 1) comprenant un mode de réalisation du dispositif de mise sous tension contrôlée conforme à l'invention.

Ce dispositif comprend, réuni entre la seconde borne 19 de l'enroulement primaire 10 et celle 2 (neutre) du réseau, un interrupteur statique bidirectionnel du type triac 20 et, en série, une résistance de mesure du courant 24 circulant dans ce triac.

Plus précisément, la seconde borne 19 de l'enroulement primaire 10 dont la première borne 18 est reliée à l'un des contacts de l'interrupteur de mise sous tension à commande manuelle 3, est reliée à la seconde borne 22 du triac 20, l'autre contact de cet interrupteur 3 étant relié à la première borne 1 (phase) du réseau.

La première borne 21 du triac 20 est reliée à l'une des bornes de la résistance de mesure 24 de faible valeur (de quelques dizaines à quelques centaines de milliohms, par exemple), choisie de façon à fournir en réponse à un courant de 6 ampères efficaces, une tension d'au moins une centaine de millivolts par exemple, l'autre borne de la résistance 24 étant reliée à la seconde borne 2 (neutre) du réseau.

Le triac 20 assurant la mise sous tension de l'enroulement primaire 10 est commandé sur sa gâchette 23 à l'aide d'impulsions récurrentes qui le déclenchent pour le rendre conducteur dans l'un ou dans l'autre sens. Ces impulsions de déclenchement sont fournies au moyen d'un circuit de commande 30 de type connu en soi, comprenant deux entrées d'alimentation 31, 32 dont la première 31 est reliée à la borne 1 (∅) du réseau à travers l'interrupteur 3 et dont la seconde 32 est directement reliée à la borne 2 (N).

Le circuit de commande 30 comporte, de préférence, un circuit intégré mnolithique 50 appelé circuit de commande de triac pour tension nulle qui permet de déclencher le triac 20 sensiblement en synchronisme avec les passages par zéro d'une tension ou d'un courant alternatif, en fournissant des implusions à chaque demi-période de celle ou de celui-ci, appliqué à une entrée de synchronisation. De nombreux circuits intégrés de ce genre sont disponibles sur le marché, tels que ceux du type GEL 300 ou PA 424 de GENERAL ELECTRIC, A 742 de FAIRCHILD SEMICONDUCTOR, CA 3059 ou CA 3079 de RCA CORPORATION ou ECG 776 de GTE SYLVANIA, par exemple. Ces circuits intégrés sont généralement conçus de façon à pouvoir être alimentés soit directement par le réseau alternatif à travers une résistance en série, au moyen d'un circuit d'alimentation incorporé, soit au moyen d'un montage redresseur, abaisseur de tension, extérieur. Il est à remarquer qu'il est également possible de réaliser des circuits de déclenchement sur des passages par zéro au moyen d'un ou de plusieurs circuits intégrés du type comparateur de tension et/ou à l'aide de circuits à composants discrets avec des résultats comparables.

Dans l'exemple de réalisation décrit et représenté ici, on utilise un circuit intégré monolithique 50 du type TEA 1511 de la société française THOMSON-EFCIS, qui comprend, notamment, un circuit d'échantillonnage et de mémorisation 51 qu'alimente l'entrée de synchronisation P3, un comparateur de tension 52 commandé par le circuit 51 et comprenant des entrées inverseuse P1 et non-inverseuse P8, un générateur d'impulsions 53 couplé respectivement à l'entrée de synchronisation P3, à une entrée d'alimentation secteur (pour le mode S) P4 ainsi qu'au circuit 51, une porte d'inhibition 54 dont une entrée complémentée est reliée à la sortie du comparateur 52 et dont l'autre entrée est reliée à la sortie du générateur d'impulsions 53. La sortie de la porte 54 est reliée à la base d'un transistor bipolaire de type NPN 55 dont l'émetteur est relié à l'entrée d'alimentation négative ($V_{EE}$) P5 du circuit 50 et dont le collecteur est relié à la sortie de commande P6 du circuit 50, qui fournit des implusions de déclenchement à la gâchette 23 du triac 20. Le circuit intégré 50 comporte en outre une entrée d'alimentation positive ($V_{CC}$) P7 qui est réunie à celle d'alimentation négative ($V_{EE}$) P5, d'une part, au moyen d'un régulateur de tension 56 et d'autre part, au moyen d'un diviseur de tension résistif 57 dont le point milieu est relié à une sortie de tension de référence P2.

Dans le cas présent, le circuit de commande 30 comprend ici, outre le circuit intégré 50, un circuit d'alimentation continue ou montage redresseur 40 comprenant en série une diode de redressement 41 dont l'anode est reliée à l'entrée d'alimentation 31, une résistance 42 d'abaissement de la tension, de forte valeur (27 kiloohms, par exemple), dont une borne est reliée à l'armature positive d'un condensateur électrochimique 43 de forte capacité (d'au moins 100 microfarads, par exemple), qui constitue la sortie positive 45 du circuit d'alimentation 40.

L'armature négative de ce condensateur 43 qui constitue la sortie négative 46 du circuit 40, est reliée à l'entrée d'alimentation 32, ainsi qu'à l'entrée d'alimentation négative P5 ($V_{EE}$) du circuit intégré 50, tandis que son armature ou sortie positive 45 est reliée à l'entrée d'alimentation positive ($V_{CC}$) P7, de telle sorte qu'il est shunté par la résistance du diviseur 57 et par le régulateur de tension 56 incorporés dans le circuit intégré 50, qui coopèrent avec la résistance d'alimentation 42 en série avec la diode 41 pour faire chuter la tension maximale appliquée à l'entrée P7 ($V_{CC}$) à une valeur compatible avec le circuit intégré 50 (9 volts environ).

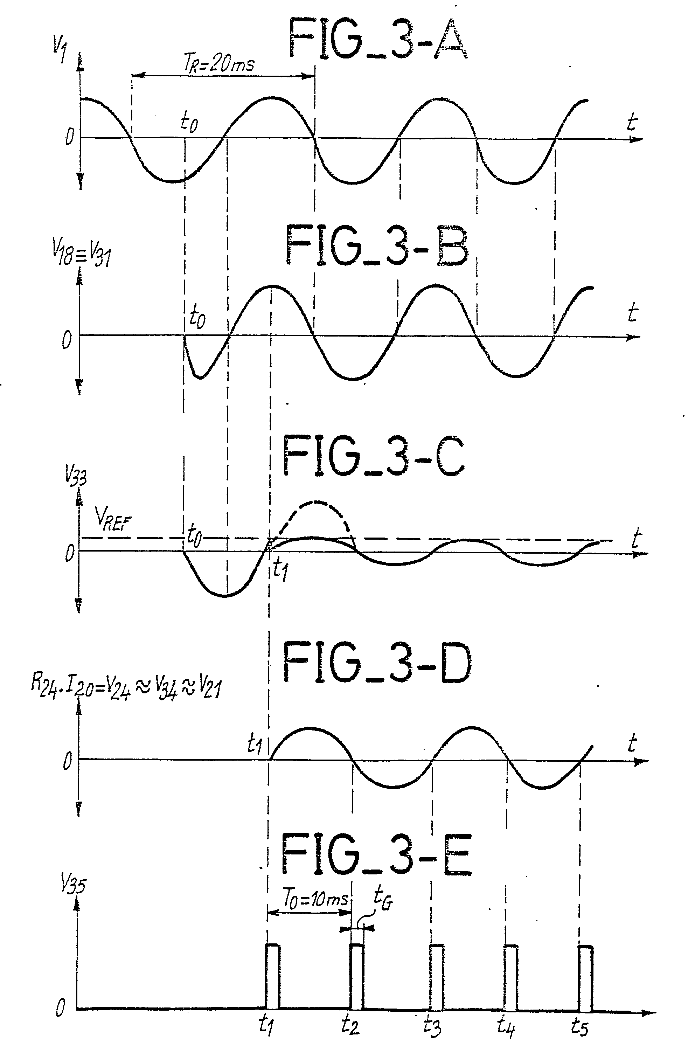

Sur les figures 3A à 3E on a respectivement représenté des variations de potentiels en fonction du temps par rapport à celui de la borne 2 (neutre) qui constitue également le potentiel de référence continu, la figure 3D représentant également le courant alternatif à travers le triac 20 ($I_{20}$), pour illustrer le fonctionnement du dispositif de la figure 2.

La figure 3A représente la tension alternative $V_1$ du réseau (de 220 V eff. à 50 Hz) qui alimente le circuit de la figure 2. Lorsque l'interrupteur 3 est fermé à l'instant $t_0$, cette tension apparaît sur la première borne 18 de l'enroulement primaire 10 du transformateur 11 et sur la borne d'alimentation 31 du circuit de commande 30. Elle ($V_{18}$) est également transmise, par l'intermédiaire de l'enroulement primaire 10, à l'autre borne 19 de celui-ci pratiquement sans déphasage, puisque le triac 20 est bloqué (en circuit ouvert), et de là, par l'intermédiaire d'un circuit déphaseur en quadrature 27, à l'entrée 33 du circuit de commande 30. Cette entrée 33 qui est reliée à l'entrée inverseuse P1 du comparateur 52, reçoit une tension $V_{33}$ illustrée sur la figure 3C, qui est déphasée de $\pi/2$ radians (ou 90°) par rapport à la tension $V_{18}$, $V_{19}$ ou $V_{22}$ qui est alors présente en amont du déphaseur 27. Ce déphaseur 27 est composé d'une résistance 25 et d'un condensateur 26 connectés en série, dont les valeurs respectives ont été choisies de manière à fournir à l'entrée 33 de commande de la première mise sous tension, une tension en quadrature de phase avec celle du réseau ($V_1$ ou $V_{18}$) et à former une impédance $Z_{27}$ dont la valeur absolue à 50 Hz soit notablement supérieure à la résistance de synchronisation utilisée pour synchroniser les déclenchements ultérieurs du triac 20 avec les passages par zéro de son courant $I_{20}$, comme expliqué plus loin.

Lorsque l'instant $t_0$ est situé, comme illustré sur les figures 3A à 3C, à proximité d'un extrémum négatif de la tension du réseau $V_1$, la tension $V_{33}$ démarre avec une alternance négative. Lorsque la tension du réseau appliquée à l'entrée d'alimentation 31 devient positive, elle commence à charger le condensateur de filtrage 43 de sorte que celui-ci alimente le circuit intégré 50 sur son entrée d'alimentation positive (P7) pour le mettre en service. Ensuite, lorsque la tension en quadrature $V_{33}$ appliquée à l'entrée inverseuse P1 du comparateur 52 atteint la tension continue de référence $V_{REF}$, prélevée sur la sortie P2 et appliquée à son entrée non-inverseuse P8, la sortie du comparateur 52 fournira un niveau « bas » qui après complémentation autorise la transmission par la porte 54 d'une impulsion engendrée par le générateur 53. Cette impulsion polarise la base du transistor 55 de telle sorte qu'à l'instant $t_1$, il fournisse sur son collecteur P6 relié à la sortie de commande 35 du circuit de commande 30, une première impulsion de tension $V_{35}$ (figure 3E). La sortie de commande 35 est reliée, au moyen d'une résistance de gâchette 29 permettant de limiter le courant, à la gâchette 23 du triac 20 de telle sorte que cette impulsion à l'instant $t_1$ le rende conducteur de manière sensiblement synchrone avec un extrémum de la tension du réseau $V_1$, quelle que soit sa polarité, grâce à la présence du montage déphaseur 27.

Si l'instant $t_0$ de fermeture se produit au cours d'une demi-période positive de la tension du réseau $V_1$, et s'il est suffisamment éloigné du passage par zéro, à la fin de cette période, pour charger le condensateur d'alimentation 43 à une tension d'alimentation adéquate, l'instant $t_1$ de la première mise sous tension de l'enroulement primaire 10, par le déclenchement du triac 20, se produit sensiblement aux alentours de l'extrémum de la demi-période négative suivante qui correspondra alors pratiquement au premier passage par zéro de la tension déphasée $V_{33}$ en quadrature, consécutif à l'instant $t_0$.

Lorsque le triac 20 a été déclenché une première fois, il continue à conduire jusqu'à la fin de la demi-période de son courant de polarité déterminée. Pour qu'il conduise en sens inverse, il faut le redéclencher lors de chaque coupure. A cette fin, on a inséré entre sa première borne (anode) 21 (proche de la gâchette 23) et la seconde borne 2 du réseau (N), une résistance de mesure 24, aux bornes de laquelle se produit une chute de tension composée sensiblement de demi-sinusoïdes alternativement de polarités opposées (figure 3D). Sur la figure 3D, qui représente également le courant qui parcourt l'enroulement primaire 10, on peut observer un déphasage sensiblement en quadrature par rapport à la tension $V_{18}$ aux bornes de celui-ci, qui est dû, notamment, à l'inductance de fuite élevée et à la présence du condensateur (4, figure 1) chargeant le circuit de l'enroulement secondaire (14, figure 1).

Pour permettre le redéclenchement du triac 20 à la fin de chaque demi-période de courant $I_{20}$, la chute de tension qui apparaît à la jonction de la première borne 21 du triac 20 avec la résistance 24 est appliquée, par l'intermédiaire d'une autre résistance de synchronisation ou de redéclenchement 28 qui, dans l'exemple, est de valeur notablement inférieure à celle de l'impédance $Z_{27}$ du circuit déphaseur RC 27, à l'entrée de sychronisation 34 du circuit de commande 30. Cette entrée 34 de synchronisation du redéclenchement est reliée à l'entrée P3 du circuit intégré 50 de telle sorte que celui-ci fournit, sensiblement à chaque passage par zéro du courant du triac 20, une impulsion de redéclenchement à sa gâchette 23 par l'intermédiaire de la sortie de commande 35 et de la résistance de gâchette 29, afin que le triac 20 soit, après son premier déclenchement à l'instant $t_1$, redéclenché à chaque demi-période T/2, c'est-à-dire aux instants $t_2 = t_1 + T/2$ $t_3 = t_1 + T,...t_n = t_1 + (n-1) T/2$ où n est un nombre entier positif, supérieur à 1, jusqu'à l'ouverture de l'interrupteur « marche-arrêt » 3.

On remarquera que dès le premier déclenchement du triac 20, l'amplitude de la tension présente à la jonction de sa seconde borne (anode) 22 avec celle 19 de l'enroulement primaire 10 et, par conséquent, la tension $V_{33}$ transmise de ce point par le montage déphaseur RC 27 à l'entrée 33, est notablement réduite, de telle sorte qu'elle n'atteigne pratiquement plus la tension de référence $V_{REF}$ fournie par la broche P2 et mette hors circuit le comparateur de tension 52 qui n'est utilisé ici que pour la première mise sous tension.

Il est à noter qu'il est également possible de réunir la borne 19 de l'enroulement 10, par l'intermédiaire du montage déphaseur 27, à la même entrée de synchronisation 34 que la résistance de redéclenchement 29, en choisissant les valeurs respectives de l'impédance $Z_{27}$ et de la résistance $R_{28}$, de telle sorte qu'en présence d'un courant $I_{20}$ dans le triac 20, l'amplitude du courant de sortie du montage déphaseur 27 soit négligeable par rapport à celle de la résistance 28.

Le comparateur 52 qu'il soit utilisé ou non pour le premier déclenchement du triac 20 après un arrêt, peut être avantageusement utilisé pour le réglage de la puissance micro-onde fournie, par le rapport cyclique du fonctionnement du magnétron (M, figure 1), à l'aide d'un signal rectangulaire récurrent de durée variable.

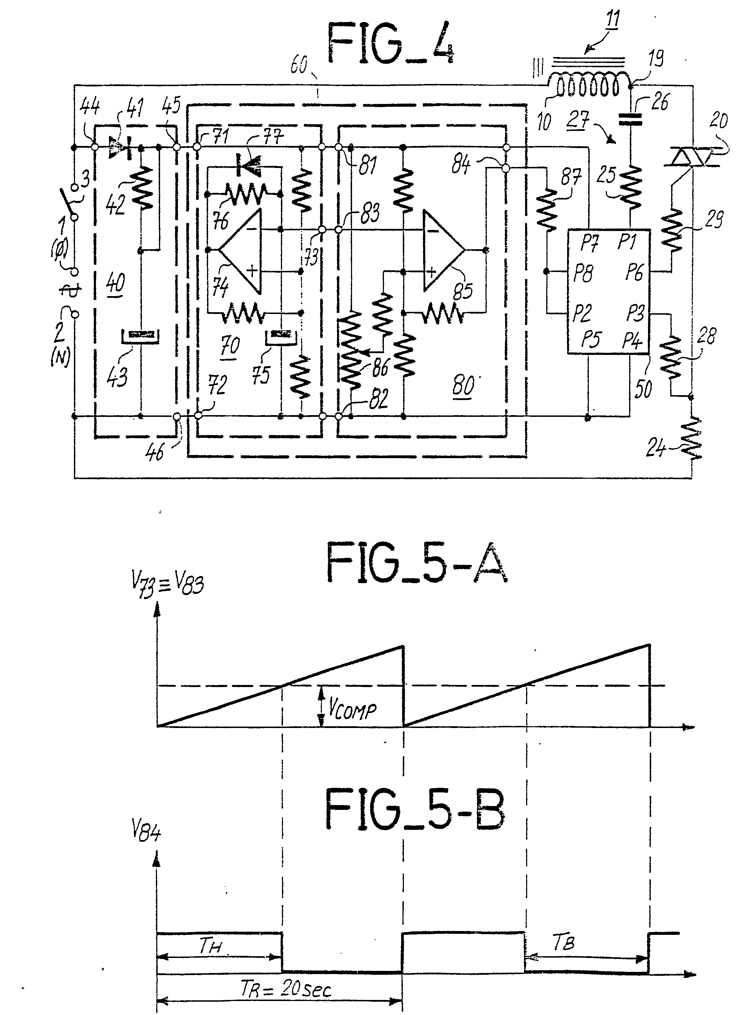

Sur la figure 4, on a représenté schématiquement un dispositif de la figure 2 complété d'un tel circuit de réglage de puissance par le rapport cyclique d'un signal périodique.

Le circuit de réglage du rapport cyclique 60 est composé en cascade d'un générateur de signaux de rampe 70 en forme de dents de scie récurrentes, illustrés sur la figure 5A, dont la période de récurrence est de 20 secondes (1000 périodes du secteur) environ, et d'un comparateur de tensions analogiques à seuil de comparaison réglable 80. Le générateur de dents de scie 70 et le comparateur 80 comportent respectivement des entrées d'alimentation positives 71 et 81 et négatives 72 et 82 qui sont respectivement reliées aux sorties d'alimentation positive 45 et négative 46 du montage redresseur-abaisseur 40 alimentant également le circuit intégré 50 de déclenchement aux passages par zéro, représenté ici par un bloc.

Le générateur de dents de scie 70 est composé d'un comparateur de tension (ou amplificateur opérationnel à gain élevé) 74 connecté au moyen de résistances, d'un condensateur et d'une diode, pour former un circuit auto-oscillant engendrant des formes d'onde en dents de scie récurrentes, à période de répétition constante, de manière connue. La sortie 73 reliée à l'entrée inverseuse du comparateur 74, au condensateur d'intégration 75, à la résistance 76 et à la diode 77 de contre-réaction, fournit une tension linéairement croissante (ou décroissante suivant la polarité de la diode 77), avec, grâce à la diode 77, un retour brusque à une tension nulle, après que la tension aux bornes du condensateur 75 ait atteint celle appliquée à l'entrée non-inverseuse du comparateur 70.

Cette tension en dents de scie $V_{73}$ qui est illustrée sur la figure 5A, est appliquée à l'entrée inverseuse d'un autre comparateur de tensions analogiques 85 dont l'entrée non-inverseuse reçoit une tension de comparaison variable $V_{COMP}$ à l'aide d'un potentiomètre 86, qui permet de faire varier le niveau de tension auquel commute le comparateur 80. Lorsque la tension $V_{73}$ de rampe est inférieure à la tension de seuil de comparaison $V_{COMP}$, la sortie 84 du comparateur 80 fournit un état « haut » représenté par une tension positive, et lorsqu'elle atteint ou dépasse cette valeur, la sortie 84 fournit une tension nulle, jusqu'à la fin de la dent de scie, où il rebascule vers l'état « haut ».

On obtient ainsi un signal rectangulaire $V_{84}$ à deux niveaux, illustré par la figure 5B, dont la durée de l'état haut $T_H$ est une fonction linéaire de la tension $V_{COMP}$ fournie par le curseur du potentiomètre 86 de réglage de la puissance moyenne $P_M$ et elle peut varier entre O et $T_R$ (c'est-à-dire $T_H = T_R$ pour $V_{COMP}$ supérieure à $V_{83MAX}$). La durée de l'état bas $T_B$ varie donc en sens inverse, puisque $T_R = T_H + T_B$.

Lorsque le signal rectangulaire récurrent $V_{84}$ est appliqué à travers une résistance 87 à l'entrée non-inverseuse $P_8$ du comparateur (52, figure 2) incorporé au circuit intégré 50, l'état haut du signal $V_{84}$ provoque la fourniture d'un état analogue à l'entrée complémentée de la porte d'inhibition (54, figure 4) de ce dernier de façon à bloquer la fourniture d'impulsions de déclenchement (d'amorçage au triac) à condition que l'amplitude de la tension $V_{33}$ déphasée en quadrature et atténuée par le montage déphaseur RC 27 soit inférieure à celle correspondant à cet état haut. On obtient ainsi une inhibition de tout déclenchement du triac 20 au cours de la durée $T_H$. Par contre, lorsque le comparateur 80 fournit un état bas, c'est-à-dire une tension nulle, l'entrée non-inverseuse P8 reçoit une faible tension de référence $V_{REF}$ qui sert de seuil pour détecter le premier passage par zéro du signal déphasé $V_{33}$ consécutif au passage du signal rectangulaire $V_{84}$ à l'état bas, afin de provoquer une première impulsion de déclenchement à la gâchette du triac 20. Pendant toute la durée $T_B$ de l'état bas, les impulsions de déclenchement suivantes seront provoquées par les passages à zéro successifs du courant $I_{20}$ du triac 20. Lorsque le signal $V_{84}$ repasse à l'état haut, le triac 20 ne sera plus redéclenché et cessera de conduire à la fin de la demi-période du secteur qui suit sa dernière impulsion de déclenchement précédant ce changement d'état.

La puissance moyenne $P_M$ fournie sera alors égale au produit de la puissance maximale par le rapport cyclique $T_B/T_R$. On notera ici que, si le signal rectangulaire $V_{84}$ est appliqué à l'entrée inverseuse P1 du comparateur (52, figure 2) incorporé, c'est le passage à l'état haut de ce signal qui autorisera la fourniture des impulsions de déclenchement à la gâchette du triac 20 et l'inhibition sera commandée par son état bas. Le rapport cyclique est alors égal à $T_H/T_R$ et peut être commandé par la variation de la position du curseur du potentiomètre 86 fournissant $V_{COMP}$.

Pour la réalisation du circuit de commande du rapport cyclique on peut utiliser un double comparateur intégré, par exemple, du type A 711 de FAIRCHILD SEMICONDUCTOR, LM 711 ou LM 358 de NATIONAL SEMICONDUCTOR ou TDB 0119 de la DIVISION SESCOSEM de THOMSON-CSF, qui peut, par exemple, également être connecté selon la publication FR-A-2 448 833, où l'on utilise un signal triangulaire à la place de la dent de scie. Si le circuit intégré 50 destiné au déclenchement du triac 20 lors des passages par zéro ne comporte pas de porte d'inhibition incorporée, il est possible d'utiliser un circuit de porte analogique inséré, par exemple, entre la sortie du déphaseur en quadrature 27 et celle des entrées du circuit intégré 50 qui permet d'assurer l'élaboration de la première impulsion de déclenchement du triac 20.

## Revendications

1. Dispositif de mise sous tension d'un circuit d'alimentation pour magnétron (M) à l'aide d'un transformateur (11) élévateur de tension à inductances de fuite élevées, dont l'enroulement secondaire (14) de très haute tension alimente un magnétron (M) et une diode (5) ou un autre magnétron respectivement connectés pour conduire dans des sens opposés, à travers un condensateur (4), l'enroulement primaire (10) du transformateur (11) étant en série avec un interrupteur statique à conduction bidirectionnelle, tel qu'un triac (20), ce dispositif étant tel que la première mise sous tension de l'enroulement primaire (10) est synchronisée, au moins approximativement, avec le premier passage par une valeur de crête de la tension alternative d'alimentation consécutif à la connexion au réseau du montage-série de cet enroulement primaire (10) et de l'interrupteur statique (20), caractérisé en ce qu'il comporte un circuit intégré de déclenchement (30) synchrone avec des passages à zéro, dont l'entrée de synchronisation (33) reçoit, avant le premier déclenchement de l'interrupteur statique (20), la tension du réseau déphasée sensiblement en quadrature, à l'aide d'un déphaseur (27), ce circuit intégré de déclenchement commandant au moins le premier déclenchement dudit interrupteur statique (20).

2. Dispositif suivant la revendication 1, caractérisé en ce que le circuit intégré (30) présente une seconde entrée (34) de synchronisation connectée de façon telle que les déclenchements de l'interrupteur statique (20) qui sont postérieurs au premier déclenchement sont synchronisés avec les passages par zéro du courant de celui-ci.

3. Dispositif suivant la revendication 1 ou 2, caractérisé en ce que, le réglage de la puissance moyenne fournie par le ou les magnétrons (M) étant assurée à l'aide d'un signal rectangulaire périodique, à fréquence de récurrence constante et à durée variable, de façon à commander le rapport cyclique de l'alimentation du ou des magnétrons, ce signal rectangulaire est appliqué à l'une des entrées (P8) du circuit intégré de déclenchement (50) de manière à inhiber la fourniture des impulsions à la gâchette de l'interrupteur statique (20), lorsqu'il correspond à un état logique prédéterminé, et à autoriser un premier déclenchement de l'interrupteur statique (20) synchrone avec une valeur crête de la tension du réseau, consécutivement au passage du signal rectangulaire dans un état logique complémentaire, ainsi que les redéclenchements successifs lors des passages par zéro de son courant, pendant la durée de cet état complémentaire.

4. Dispositif suivant l'une quelconque des revendications 1 à 3, caractérisé en ce que l'entrée du circuit déphaseur (27) dont la sortie est reliée à la première entrée (33) de synchronisation du circuit intégré (30), reçoit le signal provenant de la jonction entre l'enroulement primaire (10) du transformateur (11) et l'interrupteur statique (20).

5. Dispositif suivant les revendications 2 et 4, caractérisé en ce que la jonction (21) de l'interrupteur statique (20) avec une résistance de mesure (24) du courant dans cet interrupteur statique est réunie, au moyen d'une résistance (28) de connexion, à l'autre entrée de synchronisation (34) du circuit intégré de déclenchement (30), afin d'engendrer des impulsions de déclenchement postérieurement à la première, en synchronisme avec les passages par zéro du courant $(1_{20})$ de l'interrupteur statique (20).

6. Dispositif suivant les revendications 4 et 5, caractérisé en ce que l'impédance du circuit déphaseur (27) est notablement supérieure à la valeur de la résistance (28) de connexion.

7. Dispositif suivant la revendication 6, caractérisé en ce que le circuit déphaseur (27) et la résistance de connexion (28) sont reliées à une même entrée de synchronisation (33 ou 34).

8. Dispositif suivant l'une des revendications 5 à 7, caractérisé en ce que le circuit intégré de déclenchement (30) comporte une porte d'inhibition commandée à l'aide d'un signal rectangulaire récurrent de durée variable, destiné à commander le rapport cyclique d'alimentation du magnétron, cette porte étant agencée de façon à bloquer le passage des signaux appliqués aux entrées de synchronisation (33 ou 34) ou des impulsions engendrées en réponse à ceux-ci, lorsque le signal rectangulaire correspond à un état logique déterminé, et à autoriser ce passage, lorsqu'il correspond à un état logique complémentaire.

## Claims

1. A device for energizing a power supply of a magnetron (M) through a step-up voltage transformer (11) having elevated leakage inductances, the very high voltage secondary winding (14) of which feeds, via a capacitor (4), a magnetron (M) and a diode (5) or another magnetron respectively connected for being conductive in opposite directions the primary winding (10) of the transformer (11) being connected in series with a bidirectionally conductive static interruptor, such as a triac (20), this device being conceived in such a way that the first energizing of the primary winding (10) is synchronized, at least approximately, with the first occurrence of a peak value of the alternating feed voltage after the connection of the serial circuit including this primary winding (10) and the static interruptor (20) to the mains, characterized in that the device comprises an integrated circuit (30) for triggering synchronously with zero cross-overs, the synchronization input (33) of which receives, prior to the first triggering of the static interruptor (20), the mains voltage which is phase shifted substantially in quadrature by means of a phase shifter (27), the integrated trigger circuit controlling at least the first triggering of said static interruptor (20).

2. A device according to claim 1, characterized in that the integrated circuit (30) has a second synchronization input (34) connected in such a way that the triggerings of the static interruptor (20) that follow the first triggering are synchronized with the zero-cross-overs of its current.

3. A device according to claims 1 or 2, characterized in that, since the control of the mean power delivered by one or more magnetrons (M) is ensured by a periodical rectangular signal having a constant recurrence frequency and a variable duration, so as to control the cyclic ratio of the power supply to the one or more magnetrons, said rectangular signal is applied to one of the inputs (P8) of the integrated trigger circuit (50) in otder to inhibit the delivery of pulses to the gate of the static interruptor (20), when it corresponds to a predetermined logic state, and to enable a first triggering of the static interruptor (20) in synchronism with a peak value of the mains voltage consecutively to the transition of the rectangular signal into a complementary logic state, as well as the successive triggering operations when zero-cross-overs of its current occur during that complementary state.

4. A device according to any one of claims 1 to 3, characterized in that the input of the phase shifting circuit (27), the output of which is connected to a first synchronization input (33) of the integrated circuit (30), receives the signal issuing from the junction between the primary winding (10) of the transformer (11) and the static interruptor (20).

5. A device according to claims 2 and 4, characterized in that the junction (21) between the static interruptor (20) and a resistor (24) for measuring the current passing through this static interruptor is coupled, via a connection resistor (28), to the other synchronization input (34) of the integrated trigger circuit (30), in order to generate trigger pulses after the first pulse, in synchronism with the zero-cross-overs of the current ($1_{20}$) of the static interruptor (20).

6. A device according to claims 4 and 5, characterized in that the impedance of the phase shifting circuit (27) is sensibly higher than the resistance of the connection resistor (20).

7. A device according to claim 6, characterized in that the phase shifting circuit (27) and the connection resistor (28) are connected to the same synchronization input (33 or 43).

8. A device according to one of claims 5 to 7, characterized in that the integrated trigger circuit (30) comprises an inhibit gate controlled by a rectangular recurrence signal of variable duration, intended to control the cyclic ratio of the power supply to the magnetron, this gate being arranged so as to inhibit the passage of the signals applied to the synchronization inputs (33 or 34) or of the pulses generated in response thereto, when the rectangular signal corresponds to a predetermined logic state, and to enable this passage, when it corresponds to a complementary logic state.

**Patentansprüche**

1. Einrichtung zum Einschalten eines Stromversorgunkreises für ein Magnetron (M) mithilfe eines Aufwärtstransformators mit hohen Verlustinduktanzen, dessen Sekundärwicklung (14) sehr hoher Spannung über einen Kondensator (4) ein Magnetron (M) und eine Diode (5) bzw. ein weiteres Magnetron speist, welche in entgegengesetzter Leitrichtung angeschlossen sind, während die Primärwicklung (10) des Transformators (11) in Reihe mit einem statischen, in beiden Richtungen leitenden Schalter, etwa einem Triac (20) geschaltet ist, wobei die Einrichtung derart ist, daß das erste Einschalten der Primärwicklung (10) zumindest annähernd mit dem ersten Durchgang der Speisewechselspannung durch einen Spitzenwert nach dem Anschalten der Serienschaltung dieser Primärwicklung (10) und des statischen Schalter (20) ans Netz synchronisiert ist, dadurch gekennzeichnet, daß sie einen integrierten Triggerschaltkreis (30) besitzt, der mit Nulldurchgängen synchronisiert ist und dessen Synchronisationseingang (33) vor der ersten Auslösung des statischen Schalters (20) die um 90° mithilfe eines Phasenschiebers (27) verschobene Netzspannung zugeführt erhält, wobei dieser integrierte Triggerschaltkreis zumindest die erste Auslösung des statischen Schalters (20) bewirkt.

2. Einrichtung nach Anspruch 1, dadurch gekennzeichnet, daß der integrierte Schaltkreis (30) einen zweiten Synchronisationseingang (34) besitzt, der so geschaltet ist, daß die nach dem ersten Triggern erfolgenden Auslösungen des statischen Schalters (20) synchron mit den Nulldurchgängen des Stromes dieses Schalters erfolgen.

3. Einrichtung nach Anspruch 1 oder 2, dadurch gekennzeichnet, daß die Regelung der von dem oder den Magnetrons (M) gelieferten mittleren Leistung durch ein periodisches Rechtecksignal mit konstanter Rekurrenz und variabler Dauer bewirkt wird, womit das zyklische Schaltverhältnis der Speisung des oder der Magnetrons gesteuert wird, wobei das Rechtecksignal an einen der Eingänge (P8) des integrierten Triggerschaltkreises (50) gelegt wird, um die Zufuhr vom Impulsen an die Steuerelektrode des statischen Schalters (20) zu unterbinden, wenn er einem vorbestimmten logischen Zustand entspricht, und um ein erstes Auslösen des statischen Schalters synchron mit dem Spitzenwert der Netzspannung nach dem Übergang des rechtecksignals in einen logischen Komplementärzustand zu ermöglichen, sowie ebenso die nachfolgenden Auslösungen bei den Stromnulldurchgängen des Schalters während der Dauer dieses Komplementärzustands.

4. Einrichtung nach einem der Ansprüche 1 bis 3, dadurch gekennzeichnet, daß der Eingang des Phasenschieberkreises (27), dessen Ausgang mit dem ersten Synchronisationseingang (33) des integrierten Schaltkreises (30) verbunden ist, ein Signal aus dem Verbindungspunkt zwischen der Primärwicklung (10) des Transformators (11) und dem statischen Schalter (20) zugeführt erhält.

5. Einrichtung nach den Ansprüchen 2 und 4, dadurch gekennzeichnet, daß der Verbindungspunkt (21) des statischen Schalters (20) mit einem Widerstand (24) zur Messung des Stromes in diesem statischen Schalter über einen Verbindungswiderstand (28) mit dem anderen Synchronisationseingang (34) des integrierten Triggerschaltkreises (30) verbunden ist, um Triggerimpulse nach dem ersten Impuls synchron mit den Stromnulldurchgängen ($I_{20}$) im statischen Schalter (20) zu erzeugen.

6. Einrichtung nach den Ansprüchen 4 und 5, dadurch gekennzeichnet, daß die Impedanz des Phasenschieberkreises (27) wesentlich größer als der Wert des Verbindungswiderstands (28) ist.

7. Einrichtung nach Anspruch 6, dadurch gekennzeichnet, daß der Phasenschieberkreis (27) und der Verbindungswiderstand (28) an denselben Synchronisationseingang (33 oder 34) geschaltet sind.

8. Einrichtung nach einem der Ansprüche 5 bis 7, dadurch gekennzeichnet, daß der integrierte Triggerschaltkreis (30) ein Sperrtor besitzt, das durch ein wiederkehrendes Rechtecksignal variabler Dauer gesteuert wird und zur Steuerung des zyklischen Schaltverhältnisses der Speisung des Magnetrons bestimmt ist, wobei das Tor in der Weise betrieben wird, daß es den Durchgang der an die Synchronisationseingänge (33 oder 34) gelegten Signale oder der als Antwort darauf erzeugten Impulse blockiert, wenn das Rechtecksignal einem bestimmten logischen Zustand entspricht, oder freigibt, wenn es einem logischen Komplementärzustand entspricht.

# FIG_1

# FIG_2

0 148 085

FIG_3-A

FIG_3-B

FIG_3-C

FIG_3-D

FIG_3-E

2

# FIG_4

# FIG_5-A

# FIG_5-B

$T_R = 20\,sec$